# EUROPEAN PATENT APPLICATION

(11) **EP 4 354 490 A1**
(43) Date of publication of application: **17.04.2024**
(21) Application number: 22820135.6
(22) Date of filing: 02.06.2022
(51) Int. Cl.: H01L 21/302, C23F 1/12, H01L 21/3065

(54) **DRY ETCHING METHOD, METHOD FOR PRODUCING SEMICONDUCTOR ELEMENT, AND CLEANING METHOD**

(30) Priority: 09.06.2021 JP 2021096657
(71) Applicant: Resonac Corporation, Tokyo (JP)
(72) Inventor: IWASAKI, Jumpei, Tokyo 105-8518 (JP); MATSUI, Kazuma, Tokyo 105-8518 (JP)
(74) Representative: Strehl Schübel-Hopf & Partner
(86) International application number: PCT/JP2022/022490
(87) International publication number: WO 2022/259953

(57) **Abstract**

Provided is a dry etching method capable of selectively etching an etching object containing lanthanum as compared with a non-etching object at a sufficient etching rate without plasma. The dry etching method includes a dry etching step of bringing an etching gas containing nitrosyl fluoride into contact with a member to be etched (12) having an etching object that is to be etched by the etching gas and having a non-etching object that is not to be etched by the etching gas, to selectively etch the etching object as compared with the non-etching object without plasma. The etching object contains lanthanum.

## Description

### Technical Field

The present invention relates to a dry etching method, a method for producing a semiconductor element, and a cleaning method.

### Background Art

To use lanthanum (La) as a semiconductor element material, a technology of microfabricating a material containing lanthanum into an intended shape is required, but many lanthanum compounds have almost no vapor pressure. Hence, it is not easy to etch a material containing lanthanum by dry etching that performs etching by contact of gas or the like. Instead of the dry etching, wet etching that performs etching by contact of a drug solution has been used in many cases (for example, see PTL 1).

### Citation List

### Patent Literature

PTL 1: JP 2008-536312 A
PTL 2: JP 2007-201215 A

### Summary of Invention

### Technical Problem

However, if wet etching is used as the production process of a semiconductor element, a portion of the semiconductor element that should not be etched may also be etched, and characteristics of the semiconductor element may be lost. In other words, wet etching unfortunately etches not only an etching object to be etched but also a non-etching object that should not be etched and thus is not easy to selectively etch an etching object as compared with a non-etching object (i.e., a drug solution is difficult to have etching selectivity and thus is difficult to achieve high etching selectivity).

Meanwhile, a technology of etching a material containing lanthanum by dry etching has been disclosed. For example, PTL 2 discloses a method of dry etching lanthanum oxide by using carbon tetrafluoride as the etching gas. The technology disclosed in PTL 2, however, involves dry etching with plasma and thus requires an expensive plasma generator unfortunately.

The present invention is intended to provide a dry etching method capable of selectively etching an etching object containing lanthanum as compared with a non-etching object at a sufficient etching rate without plasma, a method for producing a semiconductor element, and a cleaning method.

### Solution to Problem

To solve the problems, aspects of the present invention are the following [1] to [7].
[1] A dry etching method including a dry etching step of bringing an etching gas containing nitrosyl fluoride into contact with a member to be etched having an etching object that is to be etched by the etching gas and having a non-etching object that is not to be etched by the etching gas, to selectively etch the etching object as compared with the non-etching object without plasma, in which the etching object contains lanthanum.
[2] The dry etching method according to the aspect [1], in which the etching gas is a gas exclusively containing nitrosyl fluoride or a mixed gas containing nitrosyl fluoride and a dilution gas.
[3] The dry etching method according to the aspect [1] or [2], in which the etching gas contains nitrosyl fluoride at a content of 1% by volume or more and 99% by volume or less.
[4] The dry etching method according to any one of the aspects [1] to [3], in which the etching object contains a compound having lanthanum and an oxygen atom.
[5] The dry etching method according to any one of the aspects [1] to [4], in which the non-etching object contains at least one of a compound having hafnium and an oxygen atom, a compound having zirconium and an oxygen atom, and a compound having silicon and an oxygen atom.
[6] A method for producing a semiconductor element, the method using the dry etching method according to any one of the aspects [1] to [5] to produce a semiconductor element, in which,
   the member to be etched is a semiconductor substrate having the etching object and the non-etching object, and
   the method includes a processing step of removing at least a part of the etching object from the semiconductor substrate by the etching.
[7] A cleaning method for cleaning the inner face of a chamber of a semiconductor element production apparatus by using the dry etching method according to any one of the aspects [1] to [5], in which,
   the member to be etched is the chamber, the chamber has a deposit adhering to the inner face of the chamber as the semiconductor element production apparatus is operated, and the deposit is the etching object, and
   the method includes a cleaning step of removing the deposit from the inner face of the chamber by the etching.

### Advantageous Effects of Invention

According to the present invention, an etching object containing lanthanum can be selectively etched as compared with a non-etching object at a sufficient etching rate without plasma.

### Brief Description of Drawings

FIG. 1 is a schematic view of an example dry etching system illustrating an embodiment of a dry etching method pertaining to the present invention; and
FIG. 2 is a view illustrating a test piece used in Examples and Comparative Examples.

### Description of Embodiments

Embodiments of the present invention will now be described. The embodiments are merely examples of the present invention, and the present invention is not limited to the embodiments. Various modifications or improvements can be made in the embodiments, and such modifications and improvements can be encompassed by the present invention.

A dry etching method pertaining to the present embodiment includes a dry etching step of bringing an etching gas containing nitrosyl fluoride (NOF) into contact with a member to be etched having an etching object that is to be etched by the etching gas and having a non-etching object that is not to be etched by the etching gas, to selectively etch the etching object as compared with the non-etching object without plasma. In the dry etching method pertaining to the present embodiment, the etching object contains lanthanum. Hereinafter, an etching method without plasma is also called "plasmaless etching".

When the etching gas is brought into contact with a member to be etched, an etching object containing lanthanum reacts with nitrosyl fluoride in the etching gas, and thus the etching object is etched. In contrast, a non-etching object such as a resist and a mask hardly reacts with nitrosyl fluoride, and thus the non-etching object is hardly etched.

By the dry etching method pertaining to the present embodiment, an etching object containing lanthanum can be selectively etched as compared with a non-etching object at a sufficient etching rate without plasma (i.e., high etching selectivity can be achieved).

For example, the etching selectivity that is the ratio of the etching rate of an etching object to the etching rate of a non-etching object can become 60 or more. The etching selectivity is preferably 80 or more and more preferably 100 or more.

By the dry etching method pertaining to the present embodiment, an etching object can be etched without plasma, and this eliminates the use of an expensive plasma generator for etching.
Accordingly, a member to be etched can be etched at low cost. Using no plasma is unlikely to cause corrosion of members included in an etching system (for example, a chamber), pipes connected to an etching system, members included in the semiconductor element production apparatus described later (for example, a chamber), pipes connected to the semiconductor element production apparatus described later, and similar members.

In the present invention, "etching" means that an etching object of a member to be etched is partially or entirely removed and accordingly the member to be etched is processed into a certain shape (for example, a three-dimensional shape) (for example, a film-shaped etching object of a member to be etched is processed to have a certain film thickness) and also means that residues or deposits of an etching object are removed from a member to be etched for cleaning, for example.

The dry etching method pertaining to the present embodiment can be used to produce a semiconductor element or to clean the inner face of a chamber of a semiconductor element production apparatus.

In other words, a method for producing a semiconductor element pertaining to the present embodiment is a semiconductor element production method of producing a semiconductor element by using the dry etching method pertaining to the present embodiment. In the method, the member to be etched is a semiconductor substrate having an etching object and a non-etching object. The method includes a processing step of removing at least a part of the etching object from the semiconductor substrate by the etching.

An example of the method for producing a semiconductor element pertaining to the present embodiment will be described. The example method for producing a semiconductor element includes a film formation step of forming a layer including an etching object on the surface of a semiconductor substrate, a mask formation step of forming a mask having a certain pattern on the etching object layer, and a processing step of etching the etching object layer formed with the mask by the dry etching method pertaining to the present embodiment. By the processing step, a portion of the etching object layer uncovered with the mask is removed. Accordingly, the above pattern is transferred onto the etching object layer, and a semiconductor element is produced.

The dry etching method pertaining to the present embodiment can also be used for cleaning as described above. In other words, a cleaning method pertaining to the present embodiment is a cleaning method for cleaning the inner face of a chamber of a semiconductor element production apparatus by using the dry etching method pertaining to the present embodiment, and the member to be etched is the chamber. The chamber has deposits adhering to the inner face of the chamber as the semiconductor element production apparatus is operated, and the deposits are the etching object. The cleaning method pertaining to the present embodiment includes a cleaning step of removing the deposits from the inner face of the chamber by the above etching.

For example, by the film formation step or the processing step in the above example method for producing a semiconductor element pertaining to the present embodiment, unnecessary deposits of an etching object may adhere to the inner face of a chamber in which the film formation step and the processing step are performed. Hence, by performing the cleaning step at the timing of one or both of completion of the film formation step and completion of the processing step, deposits can be removed from the inner face of the chamber by etching.

The dry etching method pertaining to the present embodiment, the method for producing a semiconductor element, and the cleaning method will next be described in further detail.

### [Etching gas]

The etching gas is a gas containing nitrosyl fluoride but may be a gas exclusively containing nitrosyl fluoride or a mixed gas containing nitrosyl fluoride and an additional gas. When the etching gas is a mixed gas containing nitrosyl fluoride and an additional gas, the content of nitrosyl fluoride contained in the etching gas may be, for example, 0.5% by volume or more and 99.5% by volume or less. To etch an etching object at a sufficient etching rate and a sufficient etching selectivity, the content is preferably 1% by volume or more and 99% by volume or less, more preferably 5% by volume or more and 75% by volume or less, and even more preferably 10% by volume or more and 50% by volume or less.

As the additional gas contained together with nitrosyl fluoride gas in the etching gas, a dilution gas can be used. In other words, the etching gas can be a mixed gas containing nitrosyl fluoride and a dilution gas.

As the dilution gas, an inert gas is preferred, and specifically at least one selected from nitrogen gas (N₂), helium (He), neon (Ne), argon (Ar), krypton (Kr), and xenon (Xe) may be used.

The content of the dilution gas contained in the etching gas is not specifically limited, may be, for example, 0.5% by volume or more and 99.5% by volume or less, and is preferably 1% by volume or more and 99% by volume or less, more preferably 25% by volume or more and 95% by volume or less, and even more preferably 50% by volume or more and 90% by volume or less.

### [Temperature condition in dry etching step]

In the dry etching method pertaining to the present embodiment, the temperature condition in the dry etching step is not specifically limited as long as nitrosyl fluoride can be in the form of gas at an etching pressure, may be, for example, 50°C or more and 300°C or less, and is preferably 80°C or more and 250°C or less, more preferably not less than 90°C and less than and 230°C, and even more preferably 100°C or more and 210°C or less.

When the temperature condition is within the above range, an etching object (specifically lanthanum) of a member to be etched is smoothly etched. In addition, a small load is applied to the etching system, and the etching system is likely to have a longer service life.

In the description, the temperature of the temperature condition is the temperature of a member to be etched, but the temperature of a stage that is installed in the chamber of an etching system and supports a member to be etched may be used.

### [Pressure condition in dry etching step]

In the dry etching method pertaining to the present embodiment, the pressure condition in the dry etching step is not specifically limited as long as nitrosyl fluoride can be in the form of gas at an etching temperature, may be, for example, 0.2 kPa or more and 200 kPa or less, and is preferably 1 kPa or more and 100 kPa or less, more preferably 2 kPa or more and 90 kPa or less, and even more preferably 3 kPa or more and 80 kPa or less. The flow rate of an etching gas may be appropriately set so as to maintain a constant pressure in a chamber depending on the chamber size or the performance of an exhaust apparatus that reduces the pressure in the chamber.

### [Member to be etched]

A member to be etched that is to be etched by the dry etching method pertaining to the present embodiment has an etching object and a non-etching object. The member to be etched may be a member having a portion formed from the etching object and a portion formed from the non-etching object or may be a member formed from a mixture of the etching object and the non-etching object. The member to be etched may have an additional portion other than the etching object and the non-etching object.

The member to be etched may have any shape and may be, for example, in a plate form, a foil form, a film form, a powder form, or a massive form. Examples of the member to be etched include the semiconductor substrate described above.

### [Etching object]

The etching object contains lanthanum. The lanthanum contained in the etching object may be the elemental metal of lanthanum or a compound of lanthanum. Alternatively, the lanthanum may include both the elemental metal of lanthanum and a compound of lanthanum.

The lanthanum compound may be any type, and examples include an oxide of lanthanum, a nitride of lanthanum, an oxynitride of lanthanum, an oxyfluoride of lanthanum, and a salt of lanthanum. The oxide of lanthanum means a compound composed of lanthanum and an oxygen atom (O), and the nitride of lanthanum means a compound composed of lanthanum and a nitrogen atom (N). The oxynitride of lanthanum means a compound composed of lanthanum, an oxygen atom, and a nitrogen atom, and the oxyfluoride of lanthanum means a compound composed of lanthanum, an oxygen atom, and a fluorine atom. The salt of lanthanum means a salt formed by reaction of lanthanum with an acid, and examples of the salt of lanthanum include lanthanum sulfate (La₂(SO₄)₃), lanthanum nitrate (La(NO₃)₃), and lanthanum hydrochloride (LaCl₃).

The oxide of lanthanum is a compound represented by LaₓO_{y} (x and y are each independently an integer of 1 or more) and is a compound containing lanthanum preferably at 10% by mole or more, more preferably at 20% by mole or more, and even more preferably at 30% by mole or more. Examples of the oxide of lanthanum include La₂O₃.

The nitride of lanthanum is a compound represented by LaₐN_{b} (a and b are each independently an integer of 1 or more) and is a compound containing lanthanum preferably at 10% by mole or more, more preferably at 250 by mole or more, and even more preferably at 40% by mole or more. Examples of the nitride of lanthanum include LaN.

Of these lanthanum compounds, a compound having lanthanum and an oxygen atom, that is, the oxide of lanthanum and a lanthanum salt having an oxygen atom are preferred. Examples of the lanthanum salt having an oxygen atom include lanthanum sulfate and lanthanum nitrate.

The etching object contains lanthanum (at least one of the elemental metal and a lanthanum compound) but may be formed from only lanthanum, may have a portion formed from only lanthanum and a portion formed from an additional material, or may be formed from a mixture of lanthanum and an additional material.

Examples of the mixture of lanthanum and an additional material include an alloy of lanthanum and an additional metal. The mixture of lanthanum and an additional material preferably contains the elemental metal and a lanthanum compound at a total content of 10% by mole or more, more preferably 20% by mole or more, and even more preferably 30% by mole or more.

The etching object may have any shape and may be, for example, in a plate form, a foil form, a film form, a powder form, a particulate form, or a massive form.

### [Non-etching object]

The non-etching object reacts with nitrosyl fluoride extremely slowly or reacts with nitrosyl fluoride to form a reaction product that has a low vapor pressure. Even when subjected to etching by the dry etching method pertaining to the present embodiment, the non-etching object is hardly etched. The non-etching object may be any object having the above characteristics, and, for example, at least of a compound having hafnium (Hf) and an oxygen atom, a compound having zirconium (Zr) and an oxygen atom, and a compound having silicon (Si) and an oxygen atom may be used. After etching an etching object, such a non-etching object is allowed to stay as a part of a semiconductor element on a substrate or is removed by a method such as plasma etching with boron chloride (BCl₃) as needed.

Examples of the compound having hafnium and an oxygen atom include an oxide of hafnium, an oxynitride of hafnium, and an oxyfluoride of hafnium. Examples of the oxide of hafnium include hafnium oxide (HfO₂).

Examples of the compound having zirconium and an oxygen atom include an oxide of zirconium, an oxynitride of zirconium, and an oxyfluoride of zirconium. Examples of the oxide of zirconium include zirconium oxide (ZrO₂).

Examples of the compound having silicon and an oxygen atom include an oxide of silicon, an oxynitride of silicon, and an oxyfluoride of silicon. Examples of the oxide of silicon include silicon oxides such as silicon dioxide (SiO₂).

The non-etching object is hardly etched by the dry etching method pertaining to the present embodiment, and thus the non-etching object can suppress etching the etching object by an etching gas. Hence, the non-etching object can be used as a resist or a mask for suppressing etching the etching object by an etching gas.
Examples of the material usable as the resist or the mask include hafnium oxide and zirconium oxide, which are typically removed after etching the etching object.

When a member to be etched having an etching object and a non-etching object is etched by the dry etching method pertaining to the present embodiment, the etching object can be selectively etched as compared with the non-etching object. Therefore, the dry etching method pertaining to the present embodiment can be used, for example, as a method for processing an etching object into a certain shape by using a patterned non-etching object as a mask (for example, a film shaped etching object of a member to be etched is processed to have a certain film thickness) and thus can be suitably used to produce a semiconductor element.

The non-etching object is hardly etched, and thus the non-etching object can suppress etching a portion that should not be etched in a semiconductor element. This can prevent loss of characteristics of a semiconductor element by etching.

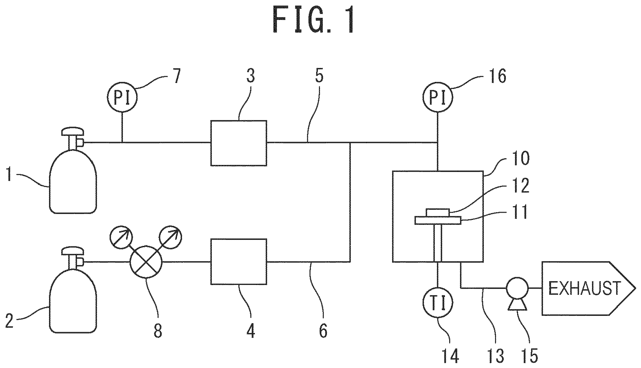

With reference to FIG. 1, an example structure of an etching system with which the dry etching method pertaining to the present embodiment can be performed and an example dry etching method by using the etching system will next be described. The etching system in FIG. 1 is a plasmaless etching system without plasma. First, the etching system in FIG. 1 will be described.

The etching system in FIG. 1 includes a chamber 10 in which etching is performed, a stage 11 for supporting, in the chamber 10, a member to be etched 12 that is to be etched, a thermometer 14 for determining the temperature of the member to be etched 12, an exhaust pipe 13 for exhausting a gas in the chamber 10, a vacuum pump 15 provided on the exhaust pipe 13 and for reducing the pressure in the chamber 10, and a pressure gauge 16 for determining the pressure in the chamber 10.

The etching system in FIG. 1 also includes an etching gas supply unit for supplying an etching gas into the chamber 10. The etching gas supply unit includes a nitrosyl fluoride gas supply unit 1 for supplying nitrosyl fluoride gas, a dilution gas supply unit 2 for supplying a dilution gas, a nitrosyl fluoride gas supply pipe 5 connecting the nitrosyl fluoride gas supply unit 1 to the chamber 10, and a dilution gas supply pipe 6 connecting the dilution gas supply unit 2 to the middle of the nitrosyl fluoride gas supply pipe 5.

On the nitrosyl fluoride gas supply pipe 5, a pressure gauge 7 for determining the pressure of nitrosyl fluoride gas and a nitrosyl fluoride gas flow controller 3 for controlling the flow rate of nitrosyl fluoride gas are provided. On the dilution gas supply pipe 6, a dilution gas pressure controller 8 for controlling the pressure of a dilution gas and a dilution gas flow controller 4 for controlling the flow rate of a dilution gas are provided.

When nitrosyl fluoride gas is supplied as the etching gas to the chamber 10, nitrosyl fluoride gas is sent from the nitrosyl fluoride gas supply unit 1 to the nitrosyl fluoride gas supply pipe 5, and accordingly the nitrosyl fluoride gas is supplied through the nitrosyl fluoride gas supply pipe 5 to the chamber 10.

When a mixed gas of nitrosyl fluoride gas with a dilution gas such as an inert gas is supplied as the etching gas, nitrosyl fluoride gas is sent from the nitrosyl fluoride gas supply unit 1 to the nitrosyl fluoride gas supply pipe 5 and the dilution gas is sent from the dilution gas supply unit 2 through the dilution gas supply pipe 6 to the nitrosyl fluoride gas supply pipe 5. Accordingly, the nitrosyl fluoride gas and the dilution gas are mixed to form a mixed gas at the middle of the nitrosyl fluoride gas supply pipe 5, and the mixed gas is supplied through the nitrosyl fluoride gas supply pipe 5 to the chamber 10. Alternatively, nitrosyl fluoride gas and a dilution gas may be separately supplied to the chamber 10 and be mixed in the chamber 10 to form a mixed gas.

The nitrosyl fluoride gas supply unit 1 and the dilution gas supply unit 2 may have any structure, which may be, for example, a tank or a cylinder. As the nitrosyl fluoride gas flow controller 3 and the dilution gas flow controller 4, for example, a mass flow controller or a flowmeter may be used.

When an etching gas is supplied to the chamber 10, the gas is preferably supplied while the supply pressure of the etching gas (i.e., the value of the pressure gauge 7 in FIG. 1) is maintained at a certain value. In other words, the supply pressure of an etching gas is preferably 10 Pa or more and 1.0 MPa or less, more preferably 100 Pa or more and 0.5 MPa or less, and even more preferably 500 Pa or more and 0.3 MPa or less. When the supply pressure of an etching gas is within the above range, the etching gas is smoothly supplied to the chamber 10, and a small load is applied on parts of the etching system in FIG. 1 (for example, the various units and tubes described above).

The pressure of the etching gas supplied into the chamber 10 is preferably 1 kPa or more and 100 kPa or less, more preferably 2 kPa or more and 90 kPa or less, and even more preferably 3 kPa or more and 80 kPa or less from the viewpoint of uniformly etching the surface of a member to be etched 12. When the pressure of the etching gas in the chamber 10 is within the above range, a lanthanum compound such as a fluoride of lanthanum smoothly volatilizes. Accordingly, a sufficient etching rate is achieved and the etching rate ratio to a non-etching object, that is, the etching selectivity is likely to be high.

The pressure in the chamber 10 before supplying an etching gas may be any value that is not more than the supply pressure of the etching gas or is lower than the supply pressure of the etching gas but, for example, is preferably not less than 10⁻⁵ Pa and less than 100 kPa and more preferably 1 Pa or more and 80 kPa or less.

The difference pressure between the supply pressure of an etching gas and the pressure in the chamber 10 before supplying the etching gas is preferably 1.0 MPa or less, more preferably 0.5 MPa or less, and even more preferably 0.3 MPa or less. When the differential pressure is within the above range, an etching gas is likely to be smoothly supplied to the chamber 10.

When an etching gas is supplied to the chamber 10, the etching gas is preferably supplied while maintained to have a certain temperature. In other words, the supply temperature of an etching gas is preferably 10°C or more and 250°C or less.

During etching, the temperature of a member to be etched 12 is preferably 80°C or more and 250°C or less, more preferably not less than 90°C and less than 230°C, and even more preferably 100°C or more and 210°C or less. Within the temperature range, an etching object of a member to be etched 12 is smoothly etched. In addition, a small load is applied to the etching system, and the etching system is likely to have a longer service life.

The processing time of etching (hereinafter also called "etching time") can be appropriately set depending on an intended etching degree of an etching object of a member to be etched 12 but is preferably within 60 minutes, more preferably within 40 minutes, and even more preferably within 30 minutes in consideration of production efficiency of a semiconductor element production process. The processing time of etching means a time from the introduction of an etching gas into the chamber 10 to the exhaust of the etching gas in the chamber 10 to complete the etching.

The dry etching method pertaining to the present embodiment can be performed by using a typical plasmaless etching system used in a semiconductor element production process, such as the etching system in FIG. 1, and the usable etching system may have any structure.

For example, the positional relation between the nitrosyl fluoride gas supply pipe 5 and the member to be etched 12 is not specifically limited as long as an etching gas can be brought into contact with the member to be etched 12. The temperature control mechanism of the chamber 10 may have any structure that can control a member to be etched 12 to have an intended temperature. Hence, a temperature control mechanism for a member to be etched 12 may be directly installed on the stage 11, or an external temperature controller may be installed to heat or cool the chamber 10 from the outside of the chamber 10.

The etching system in FIG. 1 may be formed from any material that has corrosion resistance against nitrosyl fluoride and can withstand an intended reduced pressure. For example, a part to come into contact with an etching gas may be formed from a metal such as stainless steel, a ceramic such as alumina, a fluorine resin, or a similar material. Examples of the fluorine resin include polytetrafluoroethylene (PTFE), polychlorotrifluoroethylene (PCTFE), tetrafluoroethylene-perfluoroalkoxyethylene copolymer (PFA), polyvinylidene fluoride (PVDF), Teflon (registered trademark), Viton (registered trademark), and Kalrez (registered trademark).

### [Examples]

The present invention will next be described in further detail with reference to Examples and Comparative Examples.

### (Example 1)

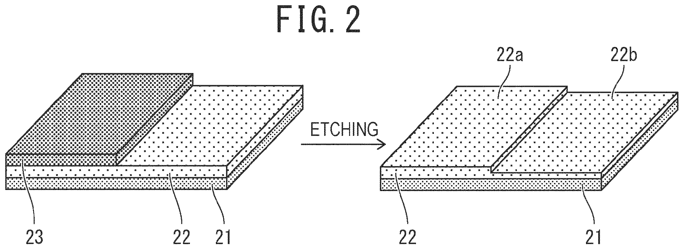

A plasmaless etching system having substantially the same structure as the etching system in FIG. 1 was used to etch a member to be etched. The member to be etched (test piece) used in Example 1 will be described with reference to FIG. 2.

A sample (manufactured by SEIREN KST) in which an oxide film 22 composed of lanthanum oxide (La₂O₃) and having a film thickness of 100 nm was formed on a 2-inch square silicon substrate 21 was prepared. Onto the oxide film 22, a 1-inch × 2-inch rectangular nickel substrate 23 (thickness: 100 nm) was bonded by using a grease (Demnum grease L-200 manufactured by Daikin Industries) to prepare a test piece. The nickel substrate 23 was so bonded as to cover almost half of the oxide film 22 as illustrated in FIG. 2.

A sample (manufactured by SEIREN KST) in which, in place of the oxide film 22 composed of lanthanum oxide, an oxide film 22 composed of hafnium oxide (HfO₂) and having a film thickness of 100 nm was formed on a silicon substrate 21 was prepared, and a nickel substrate 23 was bonded in the same manner as above to prepare a test piece. A sample (manufactured by SEIREN KST) in which, in place of the oxide film 22 composed of lanthanum oxide, an oxide film 22 composed of zirconium oxide (ZrO₂) and having a film thickness of 100 nm was formed on a silicon substrate 21 was prepared, and a nickel substrate 23 was bonded in the same manner as above to prepare a test piece. A sample (manufactured by SEIREN KST) in which, in place of the oxide film 22 composed of lanthanum oxide, an oxide film 22 composed of silicon oxide (SiO₂) and having a film thickness of 100 nm was formed on a silicon substrate 21 was prepared, and a nickel substrate 23 was bonded in the same manner as above to prepare a test piece.

These four test pieces were placed on the stage in the chamber of the etching system, and the temperature of the stage was increased to 150°C. Next, nitrosyl fluoride gas at a flow rate of 50 mL/min and argon at a flow rate of 450 mL/min were mixed to prepare a mixed gas, and the mixed gas was used as an etching gas. The etching gas was then supplied into the chamber at a flow rate of 500 mL/min and was allowed to flow for 10 minutes to perform etching.

Through the procedure, of the oxide films 22 of the four test pieces, the exposed portions uncovered with the nickel substrate 23 were etched. When the etching gas was allowed to flow, the pressure in the chamber was 40 kPa, and the partial pressure of the nitrosyl fluoride gas was 2 kPa. After completion of the etching gas flowing, the heating of the stage was stopped, and the inside of the chamber was replaced with argon.

After completion of the etching, the chamber is opened, and the test pieces were taken out. From each taken out test piece, the nickel substrate 23 was removed, and the bonded face was washed with ethanol to remove the grease. Under an atomic force microscope VN-8010 manufactured by Keyence Corporation, the level difference between a covered face 22a of the oxide film 22 that had been covered with the nickel substrate 23 and was not etched and an etched face 22b of the oxide film 22 that had been uncovered with the nickel substrate 23 and was etched was determined. The determined level difference (nm) was divided by the etching time (min) to calculate each etching rate (nm/min) of lanthanum oxide, hafnium oxide, zirconium oxide, and silicon oxide. The results are shown in Table 1.

The measurement conditions of the level differences by the atomic force microscope were as described below.
Measurement pressure: atmospheric pressure (101.3 kPa)
Measurement temperature: 28°C
Measurement atmosphere: the atmosphere
Scan field: a width of 80.0 µm, a height of 20.0 µm, an angle of 0°

From the etching rates of lanthanum oxide, hafnium oxide, zirconium oxide, and silicon oxide, the ratio (etching selectivity) of the etching rate of the etching object (lanthanum oxide) to the etching rate of each non-etching object (hafnium oxide, zirconium oxide, silicon oxide) was calculated. The results are shown in Table 1.

In Table 1, the ratio (etching selectivity) of the etching rate of lanthanum oxide to the etching rate of hafnium oxide is expressed as La₂O₃/HfO₂. Similarly, the ratio (etching selectivity) of the etching rate of lanthanum oxide to the etching rate of zirconium oxide is expressed as La₂O₃/ZrO₂, and the ratio (etching selectivity) of the etching rate of lanthanum oxide to the etching rate of silicon oxide is expressed as La₂O₃/SiO₂.

**[Table 1]**

| | Etching gas | | Stage temperature (°C) | Pressure in chamber (Pa) | Etching rate (nm/min) | | | | Etching selectivity | | |
|---|---|---|---|---|---|---|---|---|---|---|---|
| | Composition | Volume ratio¹⁾ | | | La₂O₃ | HfO₂ | ZrO₂ | SiO₂ | La₂O₃/HfO₂ | La₂O₃/ZrO₂ | La₂O₃/SiO₂ |
| Ex. 1 | NOF/Ar | 10/90 | 150 | 20 | 1.7 | less than 0.1 | less than 0.1 | less than 0.1 | more than 17 | more than 17 | more than 17 |
| Ex. 2 | NOF/Ar | 30/70 | 150 | 20 | 4.9 | less than 0.1 | less than 0.1 | less than 0.1 | more than 49 | more than 49 | more than 49 |
| Ex. 3 | NOF/Ar | 50/50 | 150 | 20 | 8.7 | 0.1 | 0.1 | 0.2 | 87.0 | 87.0 | 43.5 |
| Ex. 4 | NOF/Ar | 30/70 | 260 | 20 | 8.9 | 0.3 | 0.3 | 0.2 | 29.7 | 29.7 | 44.5 |
| Ex. 5 | NOF/Ar | 30/70 | 200 | 20 | 6.8 | 0.2 | 0.2 | 0.1 | 34.0 | 34.0 | 68.0 |
| Ex. 6 | NOF/Ar | 30/70 | 125 | 20 | 4.1 | less than 0.1 | less than 0.1 | less than 0.1 | more than 41 | more than 41 | more than 41 |
| Ex. 7 | NOF/Ar | 30/70 | 100 | 20 | 3.5 | less than 0.1 | less than 0.1 | 0.1 | more than 35 | more than 35 | 35.0 |
| Ex. 8 | NOF/Ar | 30/70 | 70 | 40 | 2.1 | less than 0.1 | less than 0.1 | 0.4 | more than 21 | more than 21 | 5.3 |
| Ex. 9 | NOF/Ar | 30/70 | 150 | 110 | 8.0 | 0.3 | 0.3 | 0.3 | 26.7 | 26.7 | 26.7 |
| Ex. 10 | NOF/Ar | 30/70 | 150 | 70 | 7.5 | 0.2 | 0.2 | 0.2 | 37.5 | 37.5 | 37.5 |
| Ex. 11 | NOF/Ar | 30/70 | 150 | 50 | 6.7 | 0.1 | 0.1 | 0.1 | 67.0 | 67.0 | 67.0 |
| Ex. 12 | NOF/Ar | 30/70 | 150 | 5 | 4.0 | less than 0.1 | less than 0.1 | less than 0.1 | more than 40 | more than 40 | more than 40 |
| Ex. 13 | NOF/Ar | 30/70 | 150 | 1 | 1.4 | less than 0.1 | less than 0.1 | less than 0.1 | more than 14 | more than 14 | more than 14 |
| Ex. 14 | NOF/Ar | 0.5/99.5 | 150 | 20 | 0.1 | less than 0.1 | less than 0.1 | less than 0.1 | more than 1 | more than 1 | more than 1 |
| Ex. 15 | NOF/Ar | 99.5/0.5 | 150 | 20 | 17.7 | 0.3 | 0.3 | 3.4 | 59.0 | 59.0 | 5.2 |
| Comp. Ex. 1 | NF₃/Ar | 30/70 | 150 | 40 | 5.6 | 0.5 | 0.4 | 0.8 | 11.2 | 14.0 | 7.0 |
| Comp. Ex. 2 | NF₃/Ar | 30/70 | 200 | 80 | 8.8 | 1.2 | 1.2 | 1.4 | 7.3 | 7.3 | 6.3 |

| | | | | | | | | | | | |
|---|---|---|---|---|---|---|---|---|---|---|---|
| ¹⁾The volume ratio of nitrosyl fluoride (NOF) gas to a dilution gas (Ar); for example, expressed as 10/90 when nitrosyl fluoride gas:dilution gas is 10:90. | | | | | | | | | | | |

### (Examples 2 to 15 and Comparative Examples 1 and 2)

Four test pieces were etched in the same manner as in Example 1 except that the etching conditions, that is, the composition and the volume ratio of the etching gas, the temperature of the stage, and the pressure in the chamber were set as shown in Table 1. Each etching rate of lanthanum oxide, hafnium oxide, zirconium oxide, and silicon oxide was calculated, and from the etching rates, the etching selectivity was calculated in the same manner as in Example 1. The results are shown in Table 1.

The results of Examples 1 to 3 and Examples 14 and 15 reveal that at a higher concentration of nitrosyl fluoride in the etching gas, lanthanum oxide as the etching object is etched at a higher etching rate. The results, however, reveal that at a nitrosyl fluoride concentration of 99.5% by volume or more, hafnium oxide, zirconium oxide, and silicon oxide as the non-etching objects are also etched. The results also reveal that at a nitrosyl fluoride concentration of 0.5% by volume or less, lanthanum oxide as the etching object is unlikely to be etched and the etching selectivity decreases.

The results of Example 2 and Examples 4 to 8 reveal that at a higher stage temperature, lanthanum oxide as the etching object is etched at a higher rate. The results, however, reveal that at a stage temperature of 260°C, the non-etching object is also etched and the etching selectivity decreases. The results also reveal that at a stage temperature of 100°C or less, silicon oxide as the non-etching object is etched and the etching selectivity (La₂O₃/SiO₂) decreases.

The results of Example 2 and Examples 9 to 13 reveal that at a higher pressure in the chamber, lanthanum oxide as the etching object is etched at a higher rate. The results, however, reveal that at a pressure of more than 50 kPa in the chamber, hafnium oxide, zirconium oxide, and silicon oxide as the non-etching objects are etched and the three etching selectivities (La₂O₃/HfO₂, La₂O₃/ZrO₂, La₂O₃/SiO₂) slightly decrease.

The results of Comparative Examples 1 and 2 reveal that when nitrogen trifluoride (NF₃) gas is used as the etching gas, lanthanum oxide as the etching object is etched at a lower rate than when nitrosyl fluoride gas is used. The results also reveal that when nitrogen trifluoride gas is used as the etching gas, the non-etching objects are also etched. The results further reveal that when nitrogen trifluoride gas is used as the etching gas, three etching selectivities (La₂O₃/HfO₂, La₂O₃/ZrO₂, La₂O₃/SiO₂) are significantly lower than when nitrosyl fluoride gas is used.

### Reference Signs List

- 1: nitrosyl fluoride gas supply unit
- 2: dilution gas supply unit
- 3: nitrosyl fluoride gas flow controller
- 4: dilution gas flow controller
- 5: nitrosyl fluoride gas supply pipe
- 6: dilution gas supply pipe
- 7: pressure gauge
- 8: dilution gas pressure controller
- 10: chamber
- 11: stage
- 12: member to be etched
- 13: exhaust pipe
- 14: thermometer
- 15: vacuum pump
- 16: pressure gauge
- 21: silicon substrate
- 22: oxide film
- 23: nickel substrate

## Claims

1. A dry etching method comprising:
a dry etching step of bringing an etching gas containing nitrosyl fluoride into contact with a member to be etched having an etching object that is to be etched by the etching gas and having a non-etching object that is not to be etched by the etching gas, to selectively etch the etching object as compared with the non-etching object without plasma, wherein
the etching object contains lanthanum.

2. The dry etching method according to claim 1,
wherein the etching gas is a gas exclusively containing nitrosyl fluoride or a mixed gas containing nitrosyl fluoride and a dilution gas.

3. The dry etching method according to claim 1 or claim 2, wherein the etching gas contains nitrosyl fluoride at a content of 1% by volume or more and 99% by volume or less.

4. The dry etching method according to any one of claims 1 to 3, wherein the etching object contains a compound having lanthanum and an oxygen atom.

5. The dry etching method according to any one of claims 1 to 4, wherein the non-etching object contains at least one of a compound having hafnium and an oxygen atom, a compound having zirconium and an oxygen atom, and a compound having silicon and an oxygen atom.

6. A method for producing a semiconductor element using the dry etching method according to any one of claims 1 to 5 to produce a semiconductor element, wherein,
the member to be etched is a semiconductor substrate having the etching object and the non-etching object, and
the method comprises a processing step of removing at least a part of the etching object from the semiconductor substrate by the etching.

7. A cleaning method for cleaning an inner face of a chamber of a semiconductor element production apparatus by using the dry etching method according to any one of claims 1 to 5, wherein,
the member to be etched is the chamber, the chamber has a deposit adhering to the inner face of the chamber as the semiconductor element production apparatus is operated, and the deposit being the etching object, and
the method comprises a cleaning step of removing the deposit from the inner face of the chamber by the etching.
